# EUROPEAN PATENT SPECIFICATION

(11) **EP 2 975 640 B1**
(45) Date of publication and mention of the grant of the patent: **30.03.2022**
(21) Application number: 15002114.5
(22) Date of filing: 16.07.2015
(51) Int. Cl.: H01L 23/42, H01L 23/373, H01L 21/04, H01L 23/367

(54) **ELECTRONIC DEVICE ASSEMBLY**
ELEKTRONISCHE VORRICHTUNGSANORDNUNG
ENSEMBLE DE DISPOSITIF ÉLECTRONIQUE

(30) Priority: 16.07.2014 US 201462025231 P; 01.04.2015 US 201514676241
(43) Date of publication of application: 20.01.2016
(73) Proprietor: GENERAL ELECTRIC COMPANY, Schenectady, NY 12345 (US)
(72) Inventor: CHAUHAN, Shakti Singh, Cupertino, California 95014 (US); JOHNSON, James Neil, Niskayuna, New York 12309 (US); HODEN, Brian Patrick, Niskayuna, New York 12309 (US); KIRK, Graham Charles, Niskayuna, New York 12309 (US)
(74) Representative: Novagraaf Group

(56) References cited:
- EP-A1- 1 542 280
- DE-A1-102006 006 538
- DE-A1-102006 007 527
- JP-A- S6 224 647
- US-A1- 2002 074 649
- US-A1- 2002 130 407
- US-A1- 2005 070 048
- US-B1- 8 174 112

## Description

### BACKGROUND

Embodiments of the present specification relate to thermal interfaces, and more particularly to thermal interface device.

DE 10 2006 006538 A1 discloses a heat sink with a base plate connected with a chip. A heat contact layer is provided between the chip and its housing made of heat conducting material with metal and crystalline carbon.

Electronic devices often produce heat during operation that needs to be dissipated away from the electronic devices to prevent over heating of one or more components of the electronic devices. As will be appreciated, overheating of the components of the electronic devices may result in reduced reliability and/or failure of the electronic devices. Heat sinks are often used for dissipating heat away from the electronic devices. A heat sink is a passive component that is used to lower a temperature of an electronic device by dissipating heat away from the electronic device into the surrounding environment. In order for the heat sink to operate efficiently, the heat from the electronic device must be transferred to the heat sink over a thermal connection.

Typically, the electronic device includes a plurality of electronic components attached to a printed circuit board (PCB). One or more of these electronic components generate heat and may be referred to as "heat sources." Heat from these multiple components is transferred to one or more heat sinks using thermal connections. Each component on the PCB is a particular distance from the heat sink (tolerance) and the heat must be effectively transferred across the tolerance from the component to the heat sink. Accordingly, the tolerance is often filled with a thermal connector, such as a compliant heat spreader and/or thermal interface material. The thermal connector serves to provide an efficient thermal connection by filling up micro voids present on a surface of a heat source and a surface of the heat sink. In addition, the thermal connector serves a mechanical function by providing a compliant mechanical connection between the heat source and the heat sink.

The thermal connector material needs to have electrically isolating and thermally conducting properties. Some examples of electrically isolating, thermally conducting materials include Gap pads, Gels and Adhesives. Typically these materials have lower break-down voltage and thus, require high thickness in application. However, with greater thickness they tend to have relatively poor thermal conductivity (<10W/mK). Therefore, they provide poor thermal performance in applications that require high levels of isolation. Conversely, other commercially available electrical isolation materials like Parylene, Teflon etc. can be made quite thin because they have high dielectric strength and resistivity. However, their thermal conductivity is considerably worse (<<1 W/mK). So they don't work with high power devices, despite a smaller thickness in application.

Therefore, there is a need for even better thermal interface devices to combat improvements dielectric as well as thermal properties.

### BRIEF DESCRIPTION

The herein claimed invention is defined in the accompanying claims.

An electronic device assembly in accordance with the invention as hereinafter claimed comprises the features of claim 1 below.

A method of assembling an electronic device in accordance with the invention as hereinafter claimed comprises the features of claim 7 below.

### DRAWINGS

FIG. 1 is a diagrammatical representation of a conventional electronic device assembly;
FIG. 2 is a schematic diagram illustrating a coated lid for use in an electronic device assembly in accordance with an embodiment of the herein claimed subject matter, while the lid as such does not constitute the herein claimed invention;
FIG. 3 is a schematic diagram illustrating an electronic device assembly, according to aspects of the present disclosure; and
FIG. 4 is a flow chart illustrating a method for assembling an electronic device, according to aspects of the present disclosure.

### DETAILED DESCRIPTION

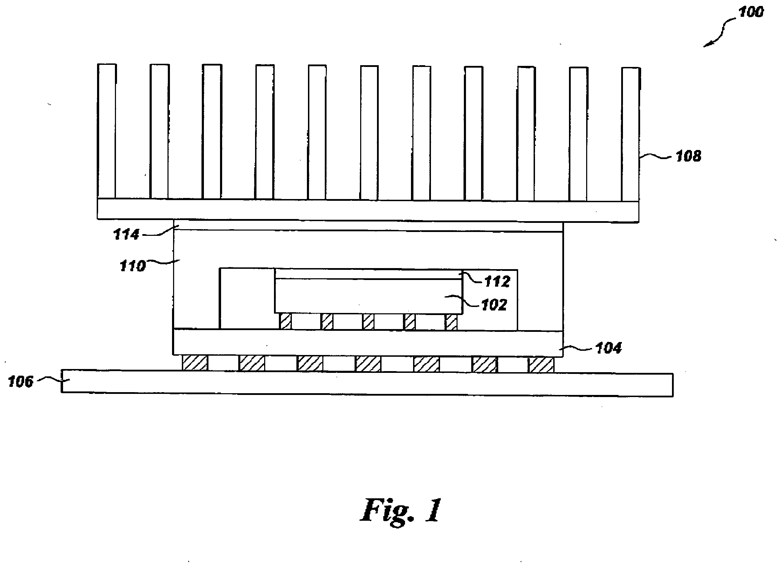

FIG. 1 illustrates a schematic view of a conventional electronic device assembly 100. In the illustrated embodiment, an electronic device such as a silicon chip 102 (also called as integrated chip) is shown. However, in other embodiments, the electronic device may be any other circuit component or a plurality of circuit components such as semiconductor switching devices, resistors and capacitors. Furthermore, in Fig. 1, only one silicon chip 102 is shown for ease of explanation, although the silicon chip 102 may be part of a larger circuit (not shown). The silicon chip 102 is mounted on a substrate 104 which is further mounted on a printed circuit board (PCB) 106.

The silicon chip 102 produces heat when energized and/or in operation. A heat sink 108 is coupled to the silicon chip 102 to dissipate the heat generated by the silicon chip into the surrounding medium. The heat sink 108 may be made from materials such as aluminum or copper alloys which have high thermal conductivity (e.g., >150 W/mk). The coupling between the heat sink 108 and the silicon chip is provided via a lid 110 (also called as heat spreader). The lid 110 is also made from high thermal conductivity material such as copper. The surfaces of silicon chip 102, heat sink 108 and lid 110 are not purely glossy or smooth. This results in reduced contact area between these components. Since a good physical contact is needed for effective heat transmission between the silicon chip 102 and heat sink 108, the lid 110 is connected to the silicon chip 102 via a thermal interface material 112. Similarly, lid 110 is also connected to the heat sink 108 by another thermal interface material 114. In one embodiment, the thermal interface materials 112 and 114 may include thermal grease which fills the contact gaps between surfaces of silicon chip 102, heat sink 108 and lid 110. Another example of thermal interface material to fill these contact gaps is a solder. However, solder is electrically conductive and also thermal grease has a lower break-down voltage which may lead to an electrical 'leakage current' between the silicon chip 102 and the heat sink 108. Furthermore, the electrical leakage current may be caused due to direct contact between silicon chip 102, lid 110 and heat sink 108.

Since the electrical leakage current flows in heat sink 108, the heat sink 108 generates an electrical noise which affects the electronic device (silicon chip) performance. Therefore, in some embodiments, the thermal interface material may include grease along with a gap pad (not shown). The gap pad has higher electrical resistance compared to the grease. However, the gap pad is thick and has poor thermal conductivity which affects heat transfer between the silicon chip 102 and heat sink 108.

In accordance with an embodiment of the present technique, a highly electrically resistive but highly thermally conducting coating on at least one of the electronic device, metallic heat spreader or the heat sink is provided. This results in an electrical isolating connection between the electronic device and the heat sink while providing an efficient heat transfer path.

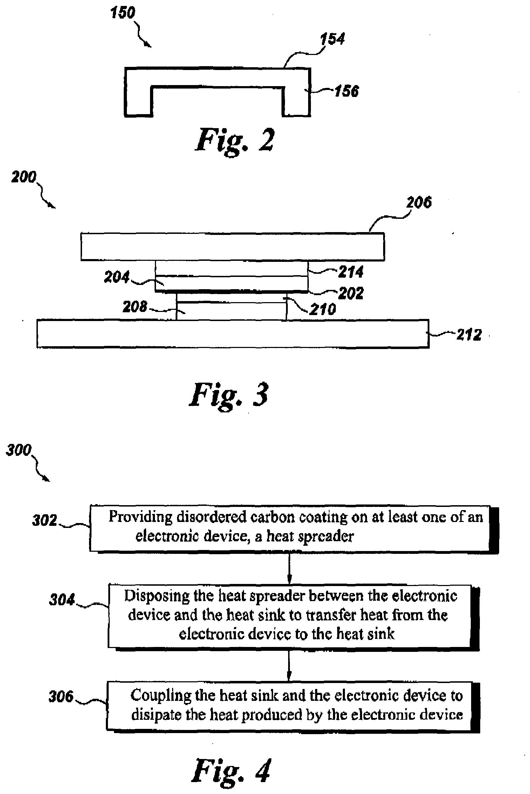

FIG. 2 shows a coated lid 150 for use in an electronic device assembly in accordance with an embodiment of the herein claimed subject matter, while the lid as such does not constitute the herein claimed invention. Coated lid 150 is formed by placing a coating 154 (shown by a dark black border) on a lid 156. In one embodiment, the coating may be provided by a powder coating process, a cold spray process, electrochemical coating process, electroplating or electroless plating process for example. By utilizing any of these or other coating processes, a thin layer of coating material is disposed on the surface of lid 156 and thus, coating 154 is formed. In one embodiment, the coating may be provided just on one surface which is in contact with the heat sink or the electronic device.

As discussed above, when a lid without any coating is put into the electronic device assembly, there may be a leakage current between the electronic device and the heat sink. The coating 154 blocks this leakage current. Since the coating 154 needs to block the leakage current, a material used for coating is a high electrical isolation material i.e., a material with high resistivity and/or high breakdown voltage properties. Furthermore, the coating material also has high thermal conductivity. In other words, the thermal resistance of the coating material is low. This is needed so as not to affect the heat transmission between the electronic device and the heat sink. In one embodiment, the thermal resistance of the coating material is lower e.g., in a large range of 10² - 10¹⁶ Ohm-cm with high break-down voltage (e.g., 100 kV/mm). The coating material has adequate mechanical strength to survive thermal cycling on metallic, High-CTE materials. The coating material is a disordered form of carbon that can be deposited on metallic substrate. The disordered form of carbon is a disordered diamond material but not diamond itself. A high SP3 DLC films which has equal to or greater than 95% SP3 content is used for the coating. High SP3 DLC films have low deposition temp. (<150C), high breakdown voltage and high thermal conductivity. In addition to the electrically isolating coating (or layer), electrically isolating thermal grease may also be utilized such that the thermal resistance can be improved further while enhancing the electrical isolation by eliminating voids or air-filled gaps between the mating surfaces.

Fig. 3 shows an electronic device assembly 200 in accordance with an embodiment of the present technique. As can be seen, a disordered Carbon Coating 202 is provided on a copper lid 204. The disordered carbon coating 202 is shown by dark line around the copper lid 204. The coated copper lid 204 is placed on to a silicon chip 208 via a first thermal interface material 210. Furthermore, the silicon chip 208 is mounted on a printed circuit board 212. The heat sink 206 is coupled to the lid 204 via a second thermal interface material 214.

It should be noted, in one embodiment, only one of the first thermal interface material 210 or the second thermal interface material 214 may be utilized. In other words, using both thermal materials 210 and 214 is not mandatory in some embodiments. As discussed earlier, the coated copper lid 204 blocks a leakage current from the silicon chip 208 to heat sink 206. Since the leakage current is blocked by the coating 202, the electrical insulation is not an issue and therefore materials such as solder and grease may be used for thermal interface materials 210 and 214. In one embodiment, gap pad may also be utilized for thermal interface material 214. It should be noted that the thickness of coating 202 is very low compared to the thickness of thermal interface materials 210 and 214.

Table 1 provides an example of thermal and insulation properties and thicknesses of various thermal interface materials and the coating. As can be seen from table 1, the first thermal interface material 210 may include materials such as grease and solder whereas the second thermal interface material 214 may include materials such as grease, solder and gap pad. Furthermore, the coating is of disordered carbon material. The electrical properties of grease thermal interface material can be insulating or conducting and that of solder can be conducting but because of the coating being insulating no leakage current can flow from silicon chip 208 to heat sink 206. The electrical property of gap pad is insulating, however, the gap pad cannot be used for 1^{st} thermal interface material 210 as it has thickness of greater than 0.3 mm. Furthermore, utilizing the insulating coating reduces the need of gap pad. The thickness of coating is in the range of 0.008 to 0.015 mm which is very low compared to the gap pad and the solder thickness of greater than 0.3 mm or even grease thickness in the range of 0.01-0.08 mm. Moreover, the thermal conductivity of the disordered carbon (>10 W/mk) is comparable to the thermal conductivity of grease (1-5 W/mk), gap pad (4-17 W/mk) and solder (17-80 W/mk).

**Table 1**

| **Interface** | **Material** | **Thickness (mm)** | **Thermal Conductivity (W/mk)** | **Electrical Property** |
|---|---|---|---|---|
| 1^{st} thermal interface material | Grease | 0.01 - 0.08 | 1 - 5 | Insulating or Conducting |
| | Solder | 0.05 - 0.2 | 17 - 80 | Conducting |
| 2^{nd} thermal interface material | Gap Pad | > 0.3 | 4 - 17 | Insulating |
| | Solder | > 0.3 | 17 - 80 | Conducting |
| | Grease | 0.01 - 0.08 | 1 - 5 | Insulating or Conducting |
| Coating | Disordered Carbon | 0.008 - 0.015 | >10 | Insulating |

Fig. 4 shows a method 300 for assembling an electronic device in accordance with an embodiment of the present technique. In step 302, the method 300 includes providing a disordered carbon coating on at least one of an electronic device or a heat spreader. In one embodiment, the disordered carbon coating may be provided only on the heat spreader or on both the heat spreader and the heat sink. The disordered carbon coating may include a high electrical isolation material i.e., a material with high resistivity and/or high breakdown voltage properties. Furthermore, the coating material also has high thermal conductivity. In one embodiment, the thermal resistance of the coating material is lower e.g., in a large range of 10² - 10¹⁶ Ohm-cm with high breakdown voltage (e.g., 100 kV/mm). The disordered form of carbon is a diamond like carbon (DLC) material. The coating is a high SP3 content DLC coating. In one embodiment, the thickness of the coating may be in the range of 0.008 - 0.015 mm, whereas the thermal conductivity of the coating may be greater than 10 W/mk.

In step 304, the method includes disposing the heat spreader between the electronic device and the heat sink to transfer the heat from the electronic device to the heat sink and in step 306 the method includes coupling the heat sink and the electronic device to dissipate the heat produced by the electronic device. In one embodiment, to couple the electronic device and the heat spreader, a first thermal interface material may be disposed between them. The first thermal interface material may include grease or solder. Furthermore, coupling the heat spreader and the heat sink may include disposing a second thermal interface material between the heat sink and the heat spreader. The second thermal interface material may include solder, grease or gap pad material. Advantages of the present technique include higher electrical and thermal performance from silicon chips that are used in challenging (high ambient temp.) environments.

## Claims

1. An electronic device assembly (200) comprising:
an electronic device (208);
a heat sink (206) coupled to the electronic device (208) to dissipate the heat produced by the electronic device;
a heat spreader (204) coupled between the electronic device (208) and the heat sink (206) to transfer heat from the electronic device to the heat sink; and wherein
a disordered carbon coating (202) disposed between the electronic device (208) and the heat spreader (204), wherein the disordered carbon coating (202) is disposed on at least one of the electronic device or the heat spreader, and includes a diamond like carbon (DLC) coating which has an SP3 content equal to or higher than 95%.

2. The electronic device assembly (200) of claim 1, further comprising a first thermal interface material (210) disposed between the electronic device (208) and the heat spreader (204).

3. The electronic device assembly of claim 2, wherein the first thermal interface material (210) includes grease or solder.

4. The electronic device assembly of any preceding claim, further comprising a second thermal interface material (214) disposed between the heat spreader (204) and the heat sink (206).

5. The electronic device assembly of claim 4, wherein the second thermal interface material (214) includes grease, solder or a gap pad.

6. The electronic device assembly of any preceding claim, wherein the disordered carbon coating (202) includes electrically resistive and thermally conducting coating.

7. A method (300) of assembling an electronic device (208), comprising:
providing (302) disordered carbon coating on at least one of the electronic device (208) and a heat spreader (204);
coupling (306) a heat sink (206) and the electronic device (208) to dissipate the heat produced by the electronic device (208);
wherein coupling the heat sink (206) and the electronic device (208) comprises disposing (304) the heat spreader (204) between the electronic device (208) and the heat sink (206) to transfer heat from the electronic device (208) to the heat sink (206); wherein
the disordered carbon coating (202) disposed between the electronic device (208) and the heat spreader (204); and wherein
providing a disordered carbon coating includes providing a diamond like carbon (DLC) coating which has an SP3 content equal to or higher than 95%.

8. The method of claim 7, wherein disposing the heat spreader (204) between the electronic device (208) and the heat sink (206) comprises providing a first thermal interface material (210) between the electronic device (208) and the heat spreader (204).

9. The method of claim 8, wherein the first thermal interface material (210) includes grease or solder.

10. The method of any of claims 7 to 9, wherein disposing the heat spreader (204) between the electronic device (208) and the heat sink (206) comprises providing a second thermal interface material (214) disposed between the heat spreader (204) and the heat sink (206).

11. The method of claim 10, wherein the second thermal interface material (214) includes grease, solder or a gap pad.

## Patentansprüche

1. Elektronische Vorrichtungsanordnung (200) umfassend:
eine elektronische Vorrichtung (208);
eine Wärmesenke (206), die mit der elektronischen Vorrichtung (208) gekoppelt ist, um die von der elektronischen Vorrichtung erzeugte Wärme abzuführen;
einen Wärmeverteiler (204), der zwischen der elektronischen Vorrichtung (208) und der Wärmesenke (206) gekoppelt ist, um Wärme von der elektronischen Vorrichtung zu der Wärmesenke zu übertragen; und wobei
eine ungeordnete Kohlenstoffbeschichtung (202), die zwischen der elektronischen Vorrichtung (208) und dem Wärmeverteiler (204) angeordnet ist, wobei die ungeordnete Kohlenstoffbeschichtung (202) auf mindestens einem von der elektronischen Vorrichtung oder dem Wärmeverteiler angeordnet ist und eine Beschichtung aus diamantartigem Kohlenstoff (DLC) mit einem SP3-Gehalt gleich oder höher als 95 % einschließt.

2. Elektronische Vorrichtungsanordnung (200) nach Anspruch 1, ferner umfassend ein erstes thermisches Grenzflächenmaterial (210), das zwischen der elektronischen Vorrichtung (208) und dem Wärmeverteiler (204) angeordnet ist.

3. Elektronische Vorrichtungsanordnung nach Anspruch 2, wobei das erste thermische Grenzflächenmaterial (210) Fett oder Lötmittel einschließt.

4. Elektronische Vorrichtungsanordnung nach einem der vorstehenden Ansprüche, ferner umfassend ein zweites thermisches Grenzflächenmaterial (214), das zwischen dem Wärmeverteiler (204) und der Wärmesenke (206) angeordnet ist.

5. Elektronische Vorrichtungsanordnung nach Anspruch 4, wobei das zweite thermische Grenzflächenmaterial (214) Fett, Lötmittel oder ein Gap-Pad einschließt.

6. Elektronische Vorrichtungsanordnung nach einem der vorstehenden Ansprüche, wobei die ungeordnete Kohlenstoffbeschichtung (202) eine mit einem elektrischem Widerstand behaftete und thermisch leitfähige Beschichtung einschließt.

7. Verfahren (300) zum Zusammenbauen einer elektronischen Vorrichtung (208), umfassend:
Bereitstellen (302) einer ungeordnete Kohlenstoffbeschichtung auf mindestens einem von der elektronischen Vorrichtung (208) und einem Wärmeverteiler (204);
Koppeln (306) einer Wärmesenke (206) und der elektronischen Vorrichtung (208), um die von der elektronischen Vorrichtung (208) erzeugte Wärme abzuführen;
wobei das Koppeln der Wärmesenke (206) und der elektronischen Vorrichtung (208) das Anordnen (304) des Wärmeverteilers (204) zwischen der elektronischen Vorrichtung (208) und der Wärmesenke (206) umfasst, um Wärme von der elektronischen Vorrichtung (208) zu der Wärmesenke (206) zu übertragen; wobei
die ungeordnete Kohlenstoffbeschichtung (202) zwischen der elektronischen Vorrichtung (208) und dem Wärmeverteiler (204) angeordnet ist; und wobei
das Bereitstellen einer ungeordneten Kohlenstoffbeschichtung das Bereitstellen einer Beschichtung aus diamantartigem Kohlenstoff (DLC) mit einem SP3-Gehalt gleich oder höher als 95 % einschließt.

8. Verfahren nach Anspruch 7, wobei das Anordnen des Wärmeverteilers (204) zwischen der elektronischen Vorrichtung (208) und der Wärmesenke (206) das Bereitstellen eines ersten thermischen Grenzflächenmaterials (210) zwischen der elektronischen Vorrichtung (208) und dem Wärmeverteiler (204) umfasst.

9. Verfahren nach Anspruch 8, wobei das erste thermische Grenzflächenmaterial (210) Fett oder Lötmittel einschließt.

10. Verfahren nach einem der Ansprüche 7 bis 9, wobei das Anordnen des Wärmeverteilers (204) zwischen der elektronischen Vorrichtung (208) und der Wärmesenke (206) das Bereitstellen eines zweiten thermischen Grenzflächenmaterials (214) umfasst, das zwischen dem Wärmeverteiler (204) und der Wärmesenke (206) angeordnet ist.

11. Verfahren nach Anspruch 10, wobei das zweite thermische Grenzflächenmaterial (214) Fett, Lötmittel oder ein Gap-Pad einschließt.

## Revendications

1. Ensemble dispositif électronique (200) comprenant :
un dispositif électronique (208) ;
un puits de chaleur (206) couplé au dispositif électronique (208) pour dissiper la chaleur produite par le dispositif électronique ;
un dissipateur de chaleur (204) couplé entre le dispositif électronique (208) et le puits de chaleur (206) pour transférer de la chaleur à partir du dispositif électronique vers le puits de chaleur ; et dans lequel
un revêtement carboné désordonné (202) placé entre le dispositif électronique (208) et le dissipateur de chaleur (204), dans lequel le revêtement carboné désordonné (202) est placé sur au moins un du dispositif électronique ou du dissipateur de chaleur, et inclut un revêtement de carbone diamantoïde (DLC) qui a une teneur en SP3 égale ou supérieure à 95 %.

2. Ensemble dispositif électronique (200) selon la revendication 1, comprenant en outre un premier matériau d'interface thermique (210) placé entre le dispositif électronique (208) et le dissipateur de chaleur (204).

3. Ensemble dispositif électronique selon la revendication 2, dans lequel le premier matériau d'interface thermique (210) inclut de la graisse ou de la soudure.

4. Ensemble dispositif électronique selon une quelconque revendication précédente, comprenant en outre un deuxième matériau d'interface thermique (214) placé entre le dissipateur de chaleur (204) et le puits de chaleur (206).

5. Ensemble dispositif électronique selon la revendication 4, dans lequel le deuxième matériau d'interface thermique (214) inclut de la graisse, de la soudure ou un plot d'espacement.

6. Ensemble dispositif électronique selon une quelconque revendication précédente, dans lequel le revêtement carboné désordonné (202) inclut un revêtement électriquement résistif et thermoconducteur.

7. Procédé (300) d'assemblage d'un dispositif électronique (208), comprenant :
la fourniture (302) d'un revêtement carboné désordonné sur au moins un d'un dispositif électronique (208) et d'un dissipateur de chaleur (204) ;
le couplage (306) d'un puits de chaleur (206) et du dispositif électronique (208) pour dissiper la chaleur produite par le dispositif électronique (208) ;
dans lequel le couplage du puits de chaleur (206) et du dispositif électronique (208) comprend la mise en place (304) du dissipateur de chaleur (204) entre le dispositif électronique (208) et le puits de chaleur (206) pour transférer de la chaleur à partir du dispositif électronique (208) vers le puits de chaleur (206) ; dans lequel
le revêtement carboné désordonné (202) placé entre le dispositif électronique (208) et le dissipateur de chaleur (204) ; et dans lequel
la fourniture d'un revêtement carboné désordonné inclut la fourniture d'un revêtement de carbone diamantoïde (DLC) qui a une teneur en SP3 égale ou supérieure à 95 %.

8. Procédé selon la revendication 7, dans lequel la mise en place du dissipateur de chaleur (204) entre le dispositif électronique (208) et le puits de chaleur (206) comprend la fourniture d'un premier matériau d'interface thermique (210) entre le dispositif électronique (208) et le dissipateur de chaleur (204).

9. Procédé selon la revendication 8, dans lequel le premier matériau d'interface thermique (210) inclut de la graisse ou de la soudure.

10. Procédé selon l'une quelconque des revendications 7 à 9, dans lequel la mise en place du dissipateur de chaleur (204) entre le dispositif électronique (208) et le puits de chaleur (206) comprend la fourniture d'un deuxième matériau d'interface thermique (214) placé entre le dissipateur de chaleur (204) et le puits de chaleur (206).

11. Procédé selon la revendication 10, dans lequel le deuxième matériau d'interface thermique (214) inclut de la graisse, de la soudure ou un plot d'espacement.
